# EUROPEAN PATENT SPECIFICATION

(11) **EP 3 199 957 B1**
(45) Date of publication and mention of the grant of the patent: **30.12.2020**
(21) Application number: 16153360.9
(22) Date of filing: 29.01.2016
(51) Int. Cl.: G01R 29/10, H04B 17/10, H04B 17/15, H04B 17/29, H01Q 13/08, H01Q 17/00, G01R 29/08, H04B 17/00, G01R 31/28

(54) **OVER THE AIR MEASUREMENT MODULE**
DRAHTLOSES MESSMODUL
MODULE DE MESURE PAR PAR LIAISON RADIO

(43) Date of publication of application: 02.08.2017
(73) Proprietor: Rohde & Schwarz GmbH & Co. KG, 81671 München (DE)
(72) Inventor: Hechtfischer, Gerd, 85591 Vaterstätten (DE); Perndl, Werner, 85604 Zorneding (DE); Tankielun, Adam, 85521 Ottobrunn (DE)
(74) Representative: Körfer, Thomas

(56) References cited:
- FR-A1- 2 976 146
- JP-A- 2009 115 644
- US-A1- 2011 125 429
- US-A1- 2015 035 707

## Description

The invention relates to an over the air measurement module for measuring high frequency signals, especially communication signals over the air.

During recent years, radio frequencies employed for performing communication tasks have continually risen. Especially with frequencies exceeding many GHz, new problems regarding the measurement of respective signals arise. By connecting the signal source to a measuring device using a cable connection, the behavior of the device under test is influenced.

For example the document US 2015/0035707 A1 shows a slot line antenna on a printed circuit board. The antenna shown there is capable of receiving high frequency signals.

Document JP 2009 115644 A shows an electric field measuring device comprising electric field sensors, a metal box of rectangular parallelpiped shape, filters, mixers and an oscillator. The electric radio frequency field received by the electric field sensors are filtered for attenuating image frequency components. The filtered signals are converted by the mixer into intermediate frequency signals. These intermediate frequency signals are provided to a field strength calculation part.

There arises the object of providing measuring means for measuring high frequency signals with a high accuracy and a small size and hardware effort.

The object is solved by the features of claim 1 for the device. The dependent claims contain further developments.

According to a first implementation, an over the air measurement module is provided. The over the air measurement module comprises an antenna, which is adapted to receive a first measuring signal from a device under test. Moreover, it comprises an analog signal processor which is directly connected to said the antenna and is adapted to reduce a frequency of the received first measuring signal, resulting in a frequency reduced first measuring signal. Furthermore, the over the air measurement module comprises a connector, connected to said analog signal processor, which is adapted to output the first frequency reduced measuring signal. It is thereby possible to acquire a measuring signal of an extremely high frequency without altering it and to provide a lower frequency measuring signal to further measuring devices.

Alternatively or additionally, the connector is adapted to receive a second frequency reduced measuring signal and provide it to the analog signal processor which is then adapted to increase a frequency of the frequency reduced second measuring signal, resulting in a second measuring signal. The antenna is then adapted to transmit this second measuring signal to the device under test. It is thereby possible to provide a measuring signal of extremely high frequency to the device under test in a controlled manner without influencing the measuring results.

According to an implementation form of the first aspect, the antenna is a planar antenna. A main radiation direction of the antenna is in the plane of the planar antenna. It is thereby possible to achieve a very low size of the over the air measurement module.

According to a further development of this implementation form, at least some surfaces, advantageously all surfaces of the measuring module facing in the main radiation direction of the antenna are adapted to absorb electromagnetic radiation and do not reflect electromagnetic radiation. Thereby, reflections towards the device under test are prevented. This increases the measuring accuracy.

According to a further implementation form, at least some surfaces, advantageously all surfaces of the measuring device facing in the main radiation direction of the antenna are coated with a paint absorbing electromagnetic radiation and/or covered with absorber material absorbing electromagnetic radiation and/or fabricated from absorber material absorbing electromagnetic radiation. It is thereby possible to further reduce reflections towards the device under test thereby increasing the measuring accuracy.

According to a further implementation form of the first aspect, at least 50% of all surfaces preferably at least 80% of all surfaces, most preferably all surfaces of the over the air measurement module facing the main radiation direction of the antenna are angled away from a normal of the main radiation direction of the antenna by at least 30°, preferably by at least 45°, most preferably by at least 60°. This further helps to reduce reflections towards the device under test, further increasing measuring accuracy.

According to a further implementation form of the first aspect, the over the air measurement module is tapered towards the main radiation direction of the antenna. First of all, this measure also reduces reflections towards the device under test, thereby increasing measuring accuracy. Also, this measure allows for an especially small foot print of the over the air measurement module. This increases the flexibility of use.

According to a further implementation form of the first aspect of the invention, if the antenna is adapted to receive the first measuring signal from the device under test, the analog signal processor is adapted to reduce the frequency of the received first measuring signal and the connector is adapted to output the first frequency reduced measuring signal, and the analog signal processor comprises a mixer, adapted to down-convert the first measuring signal to the frequency reduced first measuring signal. It is thereby possible to use regular measuring devices for measuring the frequency reduced first measuring signal without influencing the measuring result.

According to a further development of the previous implementation form, the analog signal processor further comprises a filter, adapted to perform a filtering of the first measuring signal and/or of the first frequency reduced measuring signal. Alternatively or additionally, the analog signal processor comprises a power sensor, adapted to measure the power of the first frequency reduced measuring signal. Alternatively or additionally, the analog signal processor comprises an amplifier, adapted to amplify the first measuring signal and/or the first frequency reduced measuring signal. Additionally or alternatively, the analog signal processor furthermore comprises a radio frequency switch, adapted to switch between different operating modes of the over the air measurement module. It is thereby possible to flexibly perform a post processing of the first measuring signal and signals derived therefrom.

According to a further implementation form of the first aspect, if the connector is adapted to receive the second frequency reduced measuring signal, and the analog signal processor is adapted to increase the frequency of the frequency reduced second measuring signal, and the antenna is adapted to transmit the second measuring signal to the device under test, and the analog signal processor comprises a mixer, adapted to up-convert the frequency reduced second measuring signal to the second measuring signal. It is thereby possible to generate the frequency reduced second measuring signal by for example a regular signal generator and to provide the second measuring signal of an extremely high frequency to the device under test.

According to a further development of the previous implementation form, the analog signal processor further comprises a filter, adapted to perform a filtering of the second measuring signal and/or the second frequency reduced measuring signal. Alternatively or additionally, the analog signal processor comprises an amplifier, adapted to amplify the second measuring signal and/or the second frequency reduced measuring signal. Moreover, alternatively or additionally, the analog signal processor comprises a radio frequency switch, adapted to switch between different operating modes of the over the air measurement module. It is thereby possible to flexibly perform a pre-processing of the second measuring signal before handing it to the device under test.

According to a further implementation form of the first aspect, the over the air measurement module comprises a substrate, advantageously a printed circuit board. The antenna and the analog signal processor are arranged on the substrate. The antenna is planar with the substrate. The main radiation direction of the antenna is towards an edge of the substrate. It is thereby possible to achieve an extremely small size and low footprint of the over the air measurement module.

According to a further development of the previous implementation form, the substrate has a relative permittivity εᵣ of εᵣ<4, preferably εᵣ<2, most preferably εᵣ<1.5. Additionally or alternatively, the substrate has a relative permeability µᵣ of µᵣ<3, preferably µᵣ<2, most preferably µᵣ<1.5. A very low influence of the substrate on the measuring signal is thereby achieved.

According to a further development of the previous two implementation forms, the antenna is a tapered slot line antenna, advantageously a Vivaldi antenna. It is thereby possible, to achieve satisfactory high frequency characteristics, while achieving a very small size of the antenna.

According to a further development form of the previous implementation form, the substrate comprises an opening between conductors of the tapered slot line antenna. Additionally or alternatively, a substrate bridge connects opposite parts of the tapered slot line antenna in an area of an antenna aperture. A very stable construction of the antenna with beneficial radio frequency characteristics is thereby achieved.

According to a second aspect of the invention, a measuring system comprising a previously described over the air measurement module is provided. The measuring system comprises a measuring device. The measuring device is adapted to receive and measure the frequency reduced first measuring signal from the over the air measurement module. Alternatively or additionally, the measuring device is adapted to provide the frequency reduced second measuring signal to the over the air measurement module. A very flexible and accurate measurement is thereby possible.

Exemplary embodiments of the invention are now further explained with respect to the drawings, by way of example only. The invention is, however, not limited to these embodiments. In the drawings:
- Fig. 1: shows a system with a first embodiment of the over the air measurement module and a measuring device of the invention in a top-down view;
- Fig. 2: shows the first embodiment of the over the air measurement module of the invention in a side-view;
- Fig. 3: shows a second embodiment of the over the air measurement module of the invention in a three-dimensional view; and
- Fig. 4: shows the second embodiment of the over the air measurement module of the invention in a cut-view.

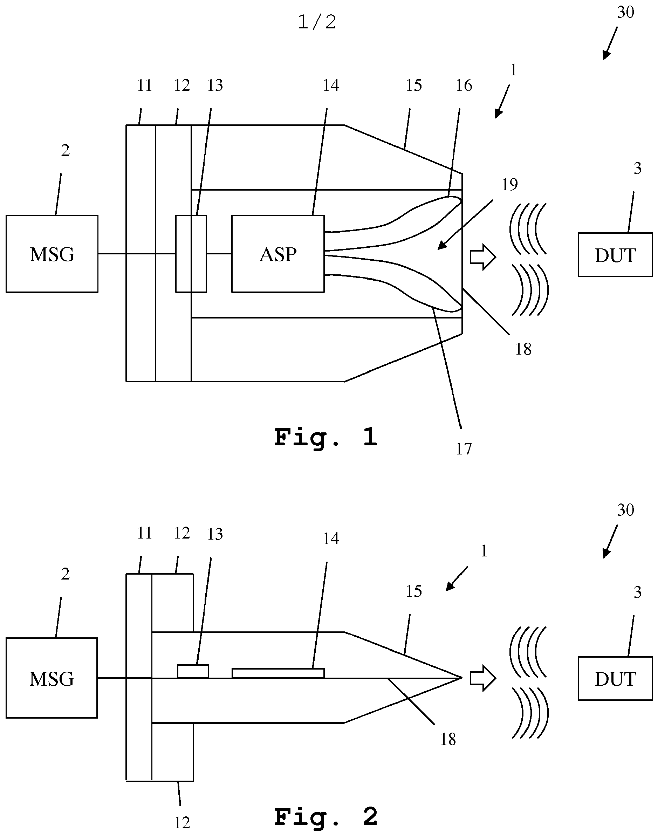

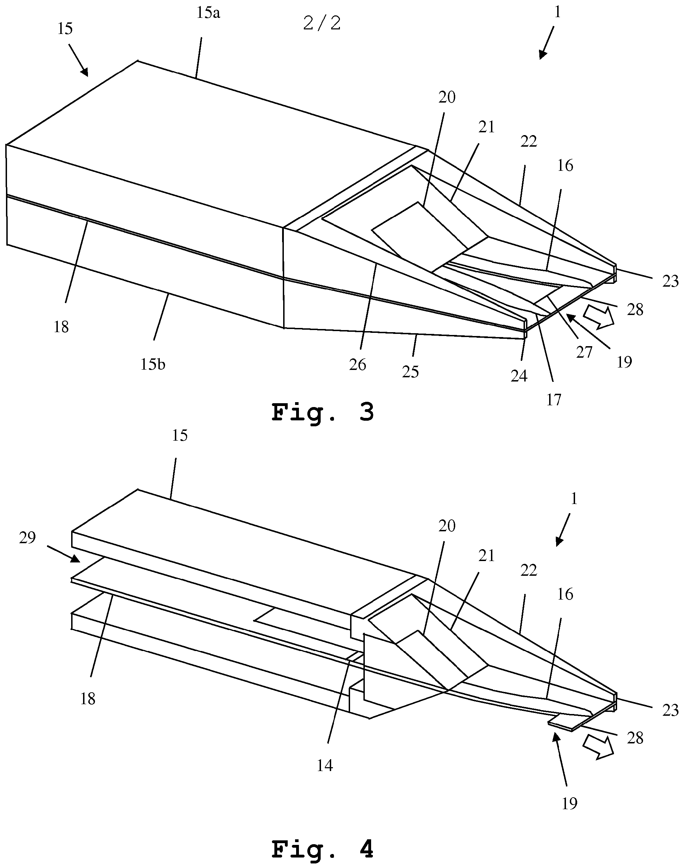

First we demonstrate the general construction and function of an over the air measurement module along Fig. 1 and Fig. 2. Along Fig. 3 and Fig. 4 further details of another implementation form are described. Similar entities and reference numbers in different figures have been partially omitted.

In Fig. 1, a first embodiment of the over the air measurement module 1 according to the first aspect of the invention is shown. The over the air measurement module 1 comprises a housing 15 which contains a substrate 18, advantageously a printed circuit board. On the substrate 18, two antenna elements 16, 17 forming a tapered slot line antenna 19, are arranged. The antenna 19 is connected to an analog signal processor 14 which is also arranged on the substrate 18. The analog signal processor moreover is connected to a connector 13 which serves as an interface 13. Connectable to the interface 13 is a measuring device 2, which is not part of the over the air measurement module 1. The antenna 19 has a main radiation direction towards the right edge of the substrate 18, indicated by an arrow in the figures. A device under test 3 is suitably arranged in this direction.

In order to minimize reflections from the over the air measurement module 1, the housing 15 is tapered towards the main radiation direction of the antenna 19. This tapering reduces the effective surface area, which can produce reflections. In order to further reduce such reflections, the housing 15 can be fabricated from an electromagnetic radiation absorbing material. It can also be covered with such a material or can be coated with an absorptive paint. The housing 15 furthermore comprises a back plate 11, which is covered with absorptive material 12 in order to further reduce reflections.

The over the air measurement module 1 is suitable for two types of measurements. In a first type of measurement, a first measuring signal emitted from the device under test 3 is received by the antenna 19 and handed to the analog signal processor 14. The analog signal processor 14 reduces the frequency of the first measuring signal resulting in a frequency reduced first measuring signal.

This is for example done by down-converting the first measuring signal using a mixer. Additionally, the analog signal processor in this case can comprise one or more filters for filtering the first measuring signal or the frequency reduced first measuring signal, a power sensor, which can be used for directly measuring a power of the frequency reduced first measuring signal, an amplifier for amplifying the first measuring signal or the first frequency reduced measuring signal, and a radio frequency switch for switching between the previously described measuring option and the measuring option described in the following. The processed frequency reduced measuring signal is then handed on to the connector 13, which passes on the signal to for example an external measuring device 2 for further processing the frequency reduced measuring signal.

Alternatively, the over the air measurement module can be used for another type of measurement. In this case, the connector 13 receives a frequency reduced second measuring signal from the measuring device 2. It is handed on to the analog signal processor 14. The analog signal processor 14 increases the frequency of the frequency reduced second measuring signal resulting in a second measuring signal. This is for example done by mixing the frequency reduced second measuring signal with a further local oscillator signal. The second measuring signal is then transmitted by the antenna 19 to the device under test 3. Also, in this case, the analog signal processor can comprise additional components. The analog signal processor can comprise a filter, for filtering the second measuring signal and/or the second frequency reduced measuring signal. Also, the analog signal processor can comprise an amplifier for amplifying the second measuring signal and/or the second frequency reduced measuring signal. Moreover, the analog signal processor can comprise a radio frequency switch, adapted to switch between different operating modes of the over the air measurement module.

Also here, the measurement system 30 according to the second aspect of the invention is depicted. The measuring system 30 comprises the over the air measurement module 1 and the measuring device 2. The measuring device 2 is adapted to receive and measure the frequency reduced first measuring signal and/or to provide the frequency reduced second measuring signal to be transmitted to the device under test 3 as second measuring signal.

In Fig. 2 the over the air measurement module of Fig. 1 is shown in a cut view from the side. Here it can be seen that the analog signal processor 14 and the connector 13 are arranged on the substrate 18. Moreover, the tapering of the housing 15 and the arrangement of the absorbers 12 can be seen.

In Fig. 3 a second embodiment of the over the air measurement module 1 is shown. Here, a three-dimensional view of the over the air measurement module 1 is depicted. The housing 15 comprises a first part 15a and a second part 15b. The two housing parts surround the substrate 18 and hold the substrate 18 between themselves. The substrate 18 comprises an opening 27 between the antenna elements 16 and 17. This opening 27 further reduces the influence of the substrate material on the received or transmitted signal. For reasons of stability, the embodiment shown here comprises a substrate bridge 28 connecting opposite parts of the tapered slot line antenna in the area of the antenna aperture.

Moreover, the over the air measurement module 1 comprises an absorber 20, which is arranged surrounding the substrate 18 at the narrow end of the tapered slot line antenna 19. The absorber 20 prevents reflections towards the device under test 2.

Moreover, in this embodiment, the geometric shape of the over the air measurement module 1 is evident. Especially, it is evident here, that the over the air measurement module 1 is tapered towards the main radiation direction of the antenna 19. Moreover, it is evident that all surfaces of the over the air measurement module 1 facing the main radiation direction of the antenna 19 are angled away from a normal of the main radiation direction of the antenna 19. This leads to an especially low reflectivity for signals emitted by the device under test 2. Here, only the very small surfaces 23, 24 point towards the device under test. All other surfaces 21, 22, 25, 26 are angled away from the device under test.

Especially, at least 50%, preferably at least 80%, most preferably all surfaces of the over the air measurement module facing the main radiation direction of the antenna are therefore angled away from a normal of the main radiation direction of the antenna by at least 30°, preferably by at least 45°, most preferably by at least 60°.

In order to further reduce the effect of the substrate 18 on the received or transmitted signal, the relative permittivity εᵣ is low. Especially, it is lower than 4, preferably εᵣ<2, most preferably εᵣ<1.5. For the same reason, the relative permeability µᵣ is low. Advantageously it is below 3, preferably µᵣ<2, most preferably µᵣ<1.5.

In Fig. 4 a cut open view of the embodiment of Fig. 3 is shown. Here it is evident that the housing 15 comprises an opening 29, which encloses the substrate 18. Arranged on the substrate 18 is the analog signal processor 14, which is connected to the antenna element 16, 17 of the antenna 19. As explained earlier, the analog signal processor 14 processes signals received by the antenna 19 and signals to be transmitted by the antenna 19. Especially the analog signal processor 14 performs a frequency conversion.

Evident from Fig. 4 is that the absorber 20 surrounds the substrate 18 on both sides in order to reduce the reflections towards the device under test.

Instead of forming the antenna 19 as depicted here, it is also possible to use two tapered slot line antennas on substrates, which are arranged orthogonally. In this case, a dual linear polarization measurement can be provided. The signals of these two antennas can be handled separately or can be combined.

Also advantageously, a power sensor can be integrated into the analog signal processor 14. A power measurement of signals received from the device under test can then be performed there. The power measurement in this case would be performed under a frequency reduced first measuring signal. In this case, a load resistor of the power sensor of the antenna has a higher value than 50 Ohm.

As a power sensor, a diode sensor produced in slot line technology can be used.

In addition, a rectification and/or a bandwidth limitation and/or an analog-digital-conversion can also be integrated into the analog signal processor. The analog signal processor 14 can moreover be adapted to provide an intermediate frequency signal or a baseband signal to the connector 13.

Advantageously, the over the air measurement module 1 is adapted to perform a wireless measurement. This means that the connector 13 can be implemented as a wireless interface for wirelessly transmitting the measuring results to the measuring device 2.

Especially, it is possible to split the measuring system 30 into an antenna module and a detector module. The antenna module would then comprise all aspects presently contained in the over the air measurement module, while the detector module would comprise at least a detector for determining certain aspects of the measured signal, for example the power of the signal. Moreover, a sensor/processing module could be separately constructed. In this case, the over the air measurement module 1 could be split into an antenna module only comprising the antenna 19 and a processing module comprising the analog signal processor 14. The antenna module, processing module and detector module can be integrated into a single module or housing. Also they can be separately constructed. Especially, an integration of the detector module and the antenna module is possible.

In order to connect the different modules, especially the sensor module, the antenna module, the detector module and the processing module, electrical conductors, for example coplanar transmission lines can be used. Also the use of optical transmission lines is possible.

In order to minimize noise, a chopper can be integrated into the detector module. By repeatedly reversing the polarity of the measured signal, the influence of noise can be mitigated. Especially, the influence of accidently coupling noise signals can be reduced.

Advantageously, the detector can be formed based on a coplanar transmission line. This allows for an easy transmission of the detected power to further components. Advantageously, the antenna signals, especially if the antenna is a slot line antenna, can be converted to a signal on a coplanar transmission line so that they can be more easily handled on the circuit board and supplied to the further components.

The change of the transmission typology from slot line to coplanar can be performed either between the antenna and the analog signal processor or between the analog signal processor and the connector.

The invention is not limited to the examples and especially not to a specific measurement direction. Also the measured signals are not limited to a specific communications task.

## Claims

1. An over the air measurement module (1), comprising:
- an antenna (19), adapted to receive a first measuring signal from a device under test (3) and/or adapted to transmit a second measuring signal to the device under test (3),
- a analog signal processor (14), directly connected to said antenna (19), adapted to reduce a frequency of the received first measuring signal, resulting in a frequency reduced first measuring signal, and/or adapted to increase a frequency of a frequency reduced second measuring signal, resulting in the second measuring signal, and
- a connector (13), connected to said analog signal processor (14), adapted to output the first frequency reduced measuring signal, and/or adapted to receive the second frequency reduced measuring signal, the over the air measurement module (1) is **characterised in that** the antenna (19) is a planar antenna (19), and wherein a main radiation direction of the antenna (19) is in the plane of the planar antenna (19), and wherein at least 50% of the surfaces (21, 22, 25, 26) of the over the air measurement module (1) facing the main radiation direction of the antenna (19) are angled away from a normal of the main radiation direction of the antenna (19) by at least 30°.

2. The over the air measurement module according to claim 1,
wherein at least some surfaces (21, 22, 23, 24, 25, 26), of the over the air measuring module (1) facing in the main radiation direction of the antenna (19) are adapted to absorb electromagnetic radiation and not reflect electromagnetic radiation.

3. The over the air measurement module according to claim 2,
wherein at least some surfaces (21, 22, 23, 24, 25, 26) of the over the air measuring module (1) facing in the main radiation direction of the antenna (19) are coated with a paint absorbing electromagnetic radiation and/or covered with absorber material absorbing electromagnetic radiation and/or fabricated from absorber material absorbing electromagnetic radiation.

4. The over the air measurement module according to any of the claims 2 to 3,
wherein at least 80%, most preferably all surfaces (21, 22, 25, 26) of the over the air measurement module (1) facing the main radiation direction of the antenna (19) are angled away from a normal of the main radiation direction of the antenna (19) by at least 45°, most preferably by at least 60°.

5. The over the air measurement module according to any of the claims 2 to 4,
wherein over the air measurement module (1) is tapered towards the main radiation direction of the antenna (19).

6. The over the air measurement module according to any of the claims 1 to 5,
wherein, if the antenna (19) is adapted to receive the first measuring signal from the device under test,
the analog signal processor (14) is adapted to reduce the frequency of the received first measuring signal, and
the connector (13) is adapted to output the first frequency reduced measuring signal, and the analog signal processor (14) comprises a mixer, adapted to down convert the first measuring signal to the frequency reduced first measuring signal.

7. The over the air measurement module according to claim 6,
wherein the analog signal processor (14) further comprises:
- a filter, adapted to perform a filtering of the first measuring signal and/or of the first frequency reduced measuring signal, and/or
- a power sensor, adapted to measure the power of the first frequency reduced measuring signal, and/or
- an amplifier, adapted to amplify the first measuring signal and/or the first frequency reduced measuring signal, and/or
- a radio frequency switch, adapted to switch between different operating modes of the over the air measurement module (1).

8. The over the air measurement module according to any of the claims 1 to 7,
wherein, if the connector (13) is adapted to receive the second frequency reduced measuring signal,
the analog signal processor (14) is adapted to increase the frequency of the frequency reduced second measuring signal,
the antenna (19) is adapted to transmit the second measuring signal to the device under test, and
the analog signal processor (14) comprises a mixer, adapted to up convert the frequency reduced second measuring signal to the second measuring signal.

9. The over the air measurement module according to claim 8,
wherein the analog signal processor (14) further comprises:
- a filter, adapted to perform a filtering of the second measuring signal and/or the second frequency reduced measuring signal, and/or
- an amplifier, adapted to amplify the second measuring signal and/or the second frequency reduced measuring signal, and/or
- a radio frequency switch, adapted to switch between different operating modes of the over the air measurement module (1).

10. The over the air measurement module according to any of the claims 1 to 9,
wherein over the air measurement module (1) comprises a substrate (18), advantageously a printed circuit board (18),
wherein the antenna (19) and the analog signal processor (14) are arranged on the substrate (18),
wherein the antenna (19) is planar with the substrate (18), and
wherein the main radiation direction of the antenna (19) is towards an edge of the substrate.

11. The over the air measurement module according to claim 10,
wherein the substrate (18) has a relative permittivity εᵣ of εᵣ < 4, preferably εᵣ < 2, most preferably εᵣ < 1.5, and/or
wherein the substrate (18) has a relative permeability µᵣ of µᵣ < 3, preferably µᵣ < 2, most preferably µᵣ < 1.5.

12. The over the air measurement module according to claim 10 or 11,
wherein the antenna (19) is a tapered slotline antenna (19), preferably a Vivaldi antenna (19).

13. The over the air measurement module according to claim 12,
wherein the substrate (18) comprises an opening (27) between conductors of the tapered slotline antenna (19), and/or
wherein a substrate bridge (28) connects opposite parts of the tapered slotline antenna (19) in an area of an antenna aperture.

14. Measuring system comprising an over the air measurement module (1) according to any of the claims 1 to 13 and a measuring device (2),
wherein the measuring device (2) is adapted to receive and measure the frequency reduced first measuring signal from the over the air measurement module (1) and/or is adapted to provide the frequency reduced second measuring signal to the over the air measurement module (1).

## Patentansprüche

1. Funkmessmodul (1), das Folgendes umfasst:
- eine Antenne (19), die angepasst ist, ein erstes Messsignal von einem Prüfling (3) zu empfangen, und/oder angepasst ist, ein zweites Messsignal zum Prüfling (3) zu übertragen,
- einen Analogsignalprozessor (14), der direkt mit der Antenne (19) verbunden ist, angepasst ist, eine Frequenz des empfangenen ersten Messsignals zu reduzieren, was in einem frequenzreduzierten ersten Messsignal resultiert, und/oder angepasst ist, eine Frequenz eines frequenzreduzierten zweiten Messsignals zu erhöhen, was in dem zweiten Messsignal resultiert, und
- einen Verbinder (13), der mit dem Analogsignalprozessor (14) verbunden ist, angepasst ist, das erste frequenzreduzierte Messsignal auszugeben, und/oder angepasst ist, das zweite frequenzreduzierte Messsignal zu empfangen,
das Funkmessmodul (1) ist **dadurch gekennzeichnet, dass** die Antenne (19) eine planare Antenne (19) ist, und
wobei eine Hauptabstrahlrichtung der Antenne (19) in der Ebene der planaren Antenne (19) liegt, und
wobei mindestens 50% der Flächen (21, 22, 25, 26) des Funkmessmoduls (1), die der Hauptabstrahlrichtung der Antenne (19) zugewandt sind, aus einer Normalen der Hauptabstrahlrichtung der Antenne (19) um mindestens 30° abgewinkelt sind.

2. Funkmessmodul nach Anspruch 1,
wobei mindestens einige Flächen (21, 22, 23, 24, 25, 26) des Funkmessmoduls (1), die in die Hauptabstrahlrichtung der Antenne (19) zeigen, angepasst sind, elektromagnetische Strahlung zu absorbieren und elektromagnetische Strahlung nicht zu reflektieren.

3. Funkmessmodul nach Anspruch 2,
wobei mindestens einige Flächen (21, 22, 23, 24, 25, 26) des Funkmessmoduls (1), die in die Hauptabstrahlrichtung der Antenne (19) zeigen, mit einer Farbe beschichtet sind, die elektromagnetische Strahlung absorbiert, und/oder mit Absorbermaterial bedeckt sind, das elektromagnetische Strahlung absorbiert, und/oder aus einem Absorbermaterial bestehen, das elektromagnetische Strahlung absorbiert.

4. Funkmessmodul nach einem der Ansprüche 2 bis 3,
wobei mindestens 80%, am bevorzugtesten alle Flächen (21, 22, 25, 26) des Funkmessmoduls (1), die der Hauptabstrahlrichtung der Antenne (19) zugewandt sind, aus einer Normalen der Hauptabstrahlrichtung der Antenne (19) um mindestens 45° abgewinkelt sind, am bevorzugtesten um mindestens 60°.

5. Funkmessmodul nach einem der Ansprüche 2 bis 4,
wobei sich das Funkmessmodul (1) zur Hauptabstrahlrichtung der Antenne (19) hin verjüngt.

6. Funkmessmodul nach einem der Ansprüche 1 bis 5,
wobei, wenn die Antenne (19) angepasst ist, das erste Messsignal vom Prüfling zu empfangen, der Analogsignalprozessor (14) angepasst ist, die Frequenz des empfangenen ersten Messsignals zu reduzieren, und der Verbinder (13) angepasst ist, das erste frequenzreduzierte Messsignal auszugeben, und der Analogsignalprozessor (14) einen Mischer umfasst, der angepasst ist, das erste Messsignal zum frequenzreduzierten ersten Messsignal nach unten zu konvertieren.

7. Funkmessmodul nach Anspruch 6,
wobei der Analogsignalprozessor (14) ferner Folgendes umfasst:
- ein Filter, das angepasst ist, eine Filterung des ersten Messsignals und/oder des ersten frequenzreduzierten Messsignals durchzuführen, und/oder
- einen Leistungssensor, der angepasst ist, die Leistung des ersten frequenzreduzierten Messsignals zu messen, und/oder
- einen Verstärker, der angepasst ist, das erste Messsignal und/oder das erste frequenzreduzierte Messsignal zu verstärken, und/oder
- einen Funkfrequenzumschalter, der angepasst ist, zwischen verschiedenen Betriebsmodi des Funkmessmoduls (1) umzuschalten.

8. Funkmessmodul nach einem der Ansprüche 1 bis 7,
wobei, wenn der Verbinder (13) angepasst ist, das zweite frequenzreduzierte Messsignal zu empfangen, der Analogsignalprozessor (14) angepasst ist, die Frequenz des frequenzreduzierten zweiten Messsignals zu erhöhen,
die Antenne (19) ist angepasst, das zweite Messsignal zum Prüfling zu übertragen, und der Analogsignalprozessor (14) umfasst einen Mischer, der angepasst ist, das frequenzreduzierte zweite Messsignal zum zweiten Messsignal nach oben zu konvertieren.

9. Funkmessmodul nach Anspruch 8,
wobei der Analogsignalprozessor (14) ferner Folgendes umfasst:
- ein Filter, das angepasst ist, eine Filterung des zweiten Messsignals und/oder des zweiten frequenzreduzierten Messsignals durchzuführen, und/oder
- einen Verstärker, der angepasst ist, das zweite Messsignal und/oder das zweite frequenzreduzierte Messsignal zu verstärken, und/oder
- einen Funkfrequenzumschalter, der angepasst ist, zwischen verschiedenen Betriebsmodi des Funkmessmoduls (1) umzuschalten.

10. Funkmessmodul nach einem der Ansprüche 1 bis 9,
wobei das Funkmessmodul (1) ein Substrat (18) umfasst, vorteilhafterweise eine Leiterplatte (18),
wobei die Antenne (19) und der Analogsignalprozessor (14) auf dem Substrat (18) angeordnet sind,
wobei die Antenne (19) mit dem Substrat (18) planar ist, und
wobei die Hauptabstrahlrichtung der Antenne (19) zu einem Rand des Substrats verläuft.

11. Funkmessmodul nach Anspruch 10,
wobei das Substrat (18) eine relative Permittivität εᵣ von εᵣ < 4 aufweist, bevorzugt εᵣ < 2, am bevorzugtesten εᵣ < 1,5, und/oder
wobei das Substrat (18) eine relative Permeabilität µᵣ von µᵣ < 3 aufweist, bevorzugt µᵣ < 2, am bevorzugtesten µᵣ < 1,5.

12. Funkmessmodul nach Anspruch 10 oder 11,
wobei die Antenne (19) eine sich verjüngende Schlitzleitungsantenne (19) ist, bevorzugt eine Vivaldiantenne (19) .

13. Funkmessmodul nach Anspruch 12,
wobei das Substrat (18) eine Öffnung (27) zwischen Leitern der sich verjüngenden Schlitzleitungsantenne (19) umfasst, und/oder
wobei eine Substratbrücke (28) gegenüberliegende Teile der sich verjüngenden Schlitzleitungsantenne (19) in einem Bereich einer Antennenapertur verbindet.

14. Messsystem, das ein Funkmessmodul (1) nach einem der Ansprüche 1 bis 13 und eine Messvorrichtung (2) umfasst,
wobei die Messvorrichtung (2) angepasst ist, das frequenzreduzierte erste Messsignal vom Funkmessmodul (1) zu empfangen und zu messen, und/oder angepasst ist, das frequenzreduzierte zweite Messsignal dem Funkmessmodul (1) bereitzustellen.

## Revendications

1. Module de mesure par liaison radio (1) comprenant :
- une antenne (19), adaptée pour recevoir un premier signal de mesure depuis un dispositif testé (3) et/ou adaptée pour transmettre un deuxième signal de mesure au dispositif testé (3),
- un processeur de signal analogique (14), directement connecté à ladite antenne (19), adapté pour réduire une fréquence du premier signal de mesure reçu, résultant en un premier signal de mesure à fréquence réduite, et/ou adapté pour augmenter une fréquence d'un deuxième signal de mesure à fréquence réduite, résultant en le deuxième signal de mesure, et
- un connecteur (13), connecté audit processeur de signal analogique (14), adapté pour délivrer le premier signal de mesure à fréquence réduite, et/ou adapté pour recevoir le deuxième signal de mesure à fréquence réduite,
le module de mesure par liaison radio (1) est **caractérisé en ce que** l'antenne (19) est une antenne (19) plane, et
dans lequel une direction de rayonnement principale de l'antenne (19) se trouve dans le plan de l'antenne (19) plane, et
dans lequel au moins 50 % des surfaces (21, 22, 25, 26) du module de mesure par liaison radio (1) faisant face à la direction de rayonnement principale de l'antenne (19) forment un angle d'au moins 30° par rapport à une normale de la direction de rayonnement principale de l'antenne (19).

2. Module de mesure par liaison radio selon la revendication 1,
dans lequel au moins certaines surfaces (21, 22, 23, 24, 25, 26), du module de mesure par liaison radio (1) orientées dans la direction de rayonnement principale de l'antenne (19) sont adaptées pour absorber le rayonnement électromagnétique et ne pas réfléchir de rayonnement électromagnétique.

3. Module de mesure par liaison radio selon la revendication 2,
dans lequel au moins certaines surfaces (21, 22, 23, 24, 25, 26) du module de mesure par liaison radio (1) orientées dans la direction de rayonnement principale de l'antenne (19) sont revêtues d'une peinture absorbant le rayonnement électromagnétique et/ou recouvertes d'un matériau absorbant qui absorbe le rayonnement électromagnétique et/ou fabriquées à partir d'un matériau absorbant qui absorbe le rayonnement électromagnétique.

4. Module de mesure par liaison radio selon l'une des revendications 2 et 3,
dans lequel au moins 80 % des surfaces (21, 22, 25, 26), de manière de loin préférée toutes, du module de mesure par liaison radio (1) faisant face à la direction de rayonnement principale de l'antenne (19), forment un angle d'au moins 45°, de manière de loin préférée d'au moins 60°, par rapport à une normale de la direction de rayonnement principale de l'antenne (19).

5. Module de mesure par liaison radio selon l'une des revendications 2 à 4,
dans lequel le module de mesure par liaison radio (1) est effilé vers la direction de rayonnement principale de l'antenne (19).

6. Module de mesure par liaison radio selon l'une des revendications 1 à 5,
dans lequel, si l'antenne (19) est adaptée pour recevoir le premier signal de mesure depuis le dispositif testé,
le processeur de signal analogique (14) est adapté pour réduire la fréquence du premier signal de mesure reçu, et
le connecteur (13) est adapté pour délivrer le premier signal de mesure à fréquence réduite, et le processeur de signal analogique (14) comprend un mélangeur, adapté pour convertir, en abaissant en fréquence, le premier signal de mesure en le premier signal de mesure à fréquence réduite.

7. Module de mesure par liaison radio selon la revendication 6,
dans lequel le processeur de signal analogique (14) comprend en outre :
- un filtre, adapté pour réaliser un filtrage du premier signal de mesure et/ou du premier signal de mesure à fréquence réduite, et/ou
- un capteur de puissance, adapté pour mesurer la puissance du premier signal de mesure à fréquence réduite, et/ou
- un amplificateur, adapté pour amplifier le premier signal de mesure et/ou le premier signal de mesure à fréquence réduite, et/ou
- un commutateur de radiofréquence, adapté pour passer d'un mode de fonctionnement à l'autre du module de mesure par liaison radio (1).

8. Module de mesure par liaison radio selon l'une des revendications 1 à 7,
dans lequel, si le connecteur (13) est adapté pour recevoir le deuxième signal de mesure à fréquence réduite,
le processeur de signal analogique (14) est adapté pour augmenter la fréquence du deuxième signal de mesure à fréquence réduite,
l'antenne (19) est adaptée pour transmettre le deuxième signal de mesure au dispositif testé, et
le processeur de signal analogique (14) comprend un mélangeur, adapté pour convertir, en montant en fréquence, le deuxième signal de mesure à fréquence réduite en le deuxième signal de mesure.

9. Module de mesure par liaison radio selon la revendication 8,
dans lequel le processeur de signal analogique (14) comprend en outre :
- un filtre, adapté pour réaliser un filtrage du deuxième signal de mesure et/ou le deuxième signal de mesure à fréquence réduite, et/ou
- un amplificateur, adapté pour amplifier le deuxième signal de mesure et/ou le deuxième signal de mesure à fréquence réduite, et/ou
- un commutateur de radiofréquence, adapté pour passer d'un mode de fonctionnement à l'autre du module de mesure par liaison radio (1).

10. Module de mesure par liaison radio selon l'une des revendications 1 à 9,
dans lequel le module de mesure par liaison radio (1) comprend un substrat (18), avantageusement une carte de circuit imprimé (18),
dans lequel l'antenne (19) et le processeur de signal analogique (14) sont agencés sur le substrat (18),
dans lequel l'antenne (19) est plane par rapport au substrat (18), et
dans lequel la direction de rayonnement principale de l'antenne (19) est dirigée vers un bord du substrat.

11. Module de mesure par liaison radio selon la revendication 10,
dans lequel le substrat (18) a une permittivité relative εr, où εr < 4, de préférence εr < 2, de manière de loin préférée εr < 1,5, et/ou
dans lequel le substrat (18) a une perméabilité relative µr, où µr r < 3, de préférence µr < 2, de manière de loin préférée µr < 1,5.

12. Module de mesure par liaison radio selon la revendication 10 ou 11,
dans lequel l'antenne (19) est une antenne (19) de ligne à fente effilée, de préférence une antenne (19) Vivaldi.

13. Module de mesure par liaison radio selon la revendication 12
dans lequel le substrat (18) comprend un orifice (27) entre des conducteurs de l'antenne (19) de ligne à fente effilée, et/ou
dans lequel un pont de substrat (28) connecte des parties opposées de l'antenne (19) de ligne à fente effilée dans une zone d'une ouverture d'antenne.

14. Système de mesure comprenant un module de mesure par liaison radio (1) selon l'une des revendications 1 à 13 et un dispositif de mesure (2),
dans lequel le dispositif de mesure (2) est adapté pour recevoir et mesurer le premier signal de mesure à fréquence réduite depuis le module de mesure par liaison radio (1) et/ou est adapté pour fournir le deuxième signal de mesure à fréquence réduite au module de mesure par liaison radio (1).
